Europäisches Patentamt

European Patent Office

Office européen des brevets

(11) Numéro de publication: **0 211 715**
**A1**

(12) # DEMANDE DE BREVET EUROPEEN

(21) Numéro de dépôt: 86401455.0

(22) Date de dépôt: 01.07.86

(51) Int. Cl.⁴: **G02B 5/18 , G02B 27/44 ,**
**G02B 5/32 , G03F 7/10**

(30) Priorité: 09.07.85 FR 8510480

(43) Date de publication de la demande:
25.02.87 Bulletin 87/09

(84) Etats contractants désignés:
DE GB

(71) Demandeur: **THOMSON-CSF**
**173, Boulevard Haussmann**
**F-75379 Paris Cedex 08(FR)**

(72) Inventeur: **Huignard, Jean-Pierre**
**THOMSON-CSF SCPI 19, avenue de Messine**
**F-75008 Paris(FR)**
Inventeur: **Nyeki, Pierre**
**THOMSON-CSF SCPI 19, avenue de Messine**
**F-75008 Paris(FR)**
Inventeur: **Illiaquer, Gérard**
**THOMSON-CSF SCPI 19, avenue de Messine**
**F-75008 Paris(FR)**
Inventeur: **Loiseaux, Brigitte**
**THOMSON-CSF SCPI 19, avenue de Messine**
**F-75008 Paris(FR)**
Inventeur: **Remy, Bertrand**
**THOMSON-CSF SCPI 19, avenue de Messine**
**F-75008 Paris(FR)**
Inventeur: **Meyzonnette, Jean-Louis**
**THOMSON-CSF SCPI 19, avenue de Messine**
**F-75008 Paris(FR)**

(74) Mandataire: **Lepercque, Jean et al**
**THOMSON-CSF SCPI 19, avenue de Messine**
**F-75008 Paris(FR)**

(54) **Procédé de réalisation d'une structure diffractante dans le domaine de l'infrarouge, et structure ainsi réalisée.**

(57) Le procédé selon l'invention comprend la création d'un relief superficiel sur un substrat ($S_b$) en matériau semiconducteur par immersion dans une solution oxydante (10) et exposition à un rayonnement photonique (3). Dans une première variante, l'exposition est réalisée en faisant interférer deux faisceaux de lumière cohérente. Dans une seconde variante, l'exposition s'effectue au travers d'un masque à l'aide d'une source de lumière incohérente.

Application notamment à la réalisation d'hologramme lisibles à 10,6 micromètres.

FIG_3

SYSTEME DE PROJECTION

# PROCEDE DE REALISATION D'UNE STRUCTURE DIFFRACTANTE DANS LE DOMAINE DE L'INFRAROUGE ET STRUCTURE AINSI REALISEE.

La présente invention concerne un procédé de réalisation de structures diffractantes ou réseaux optiques dans le domaine des longueurs d'onde infrarouges et plus particulièrement dans un domaine centré sur la longueur d'onde $\lambda$ = 10,6 micromètres, notamment pour des applications holographiques.

De nombreuses configurations de réseaux sont connues. Un type courant est constitué par des variations superficielles de relief d'une couche de matériau approprié. Un tel réseau peut être lu, selon les cas, en transmission ou en réflexion, après métallisation de la structure en relief pour ce dernier cas.

Un réseau est caractérisé par au moins deux paramètres : la profondeur des reliefs et le pas du réseau.

Il existe d'ailleurs des réseaux à pas constant et des réseaux à pas variable. Dans ce dernier cas, on peut définir un pas moyen. Pour simplifier, sans que cela soit limitatif, on se placera dans ce qui suit dans le cas d'un pas constant.

Naturellement, le pas doit être relié à la longueur d'onde utilisée pour la lecture d'un tel réseau, par exemple pour la lecture d'un hologramme.

Par analogie aux réseaux lamellaires, dont le relief est peu accentué, on appellera, dans ce qui suit, réseaux "profonds", ceux dont la caractéristique est de présenter un rapport $(d/\Lambda) > 0,2$ en transmission et $0,2 < (d/\Lambda) < 0,6$ en réflexion, rapport dans lequel $d$ est la profondeur et $\Lambda$ le pas du réseau. L'étude de l'évolution du rendement de diffraction avec les paramètres $d$ et $\Lambda$, du profil d'un réseau de relief montre qu'il existe pour chaque type de profil une valeur du rapport $d/\Lambda$ qui optimise le rendement de diffraction. Des efficacités importantes, supérieures à 75% peuvent ainsi être obtenues pour des valeurs de ce rapport compris entre un et deux. Le rendement peut atteindre, pour certaines configurations, une valeur proche de l'unité.

Pour ces réseaux "profonds", les propriétés en rendement de diffraction sont peu sensibles à l'incidence et la polarisation de l'onde de lecture. Ils permettent donc de couvrir un champ d'applictions plus large que les réseaux lamellaires.

Ces propriétés intéressantes concernant le rendement de diffraction des réseaux "profonds" ont pu être confirmées par l'expérience, avec des pas de franges inférieurs au micron, dans le domaine du visible..

Pour être compatible avec des applications du domaine infrarouge, ces réseaux profonds devraient présenter les caractéristiques suivantes:

$\Lambda \approx \lambda$ avec $\lambda$ = 10,6 micromètres

soit : $d \geq 3$ micromètres.

Or les techniques classiques, utilisées dans le domaine du visible, telles que photoresist, usinage ionique ou attaque chimique ne sont compatibles qu'avec des profondeurs de l'ordre de grandeur du micromètre. On ne peut donc les mettre en oeuvre dans le cadre d'applications visées par l'invention.

L'invention se fixe pour but de proposer un procédé permettant la réalisation de structures diffractantes dans le domaine des ondes infrarouges du type réseaux profonds.

L'invention a donc pour objet un procédé de réalisation d'une structure diffractante dans le domaine des longueurs d'ondes infrarouges sur un substrat en matériau semiconducteur, caractérisé en ce qu'il comprend des étapes d'immersion dudit substrat dans une solution oxydante et d'exposition sélective d'une zone superficielle de ce substrat à un rayonnement photonique générateur de paires de porteurs électron-trou de manière à opérer une gravure photoélectrochimique de ladite zone superficielle et en ce que le temps d'exposition est sélectionné pour que la gravure présente des micro-reliefs de hauteur supérieure ou égale à la distance moyenne séparant deux microreliefs contigüs.

L'invention a encore pour objet une structure diffractante dans le domaine des longueurs d'infrarouges réalisée par ce procédé.

L'invention sera mieux comprise et d'autres avantages et caractéristiques apparaîtront à l'aide de la description qui suit en référence aux figures annexées et parmi lesquelles :

-la figure 1 illustre schématiquement les étapes du procédé selon l'invention ;

-les figures 3 à 6 illustrent de façon plus détaillée des étapes du procédé de l'invention selon une première variante ;

-la figure 7 illustre schématiquement le procédé de l'invention selon une deuxième variante ;

-les figures 8 à 11 illustrent schématiquement une variante supplémentaire du procédé selon l'invention ;

-les figures 12 et 13 illustrent deux configurations de réseaux optiques obtenus par le procédé de l'invention.

Selon une caractéristique importante de l'invention, la gravure d'un relief particulier est obtenu par gravure photochimique d'un matériau semiconducteur.

Parmi ces matériaux, on peut citer le germanium, le silicium, l'arséniure de gallium (GaAs) ou le phosphure d'indium (InP).

Les phénomènes physiques mis en oeuvre vont tout d'abord être rappelés.

Le procédé de gravure consiste à générer, près de la surface du semiconducteur, à l'aide d'une irradiation par une source de lumière, des paires de porteurs électron-trou qui vont favoriser des réactions d'oxydation électrochimique de la surface, celle-ci étant mise en contact avec une solution oxydante qui, en outre, contient des éléments nécessaires à la dissolution de l'oxyde formé.

La source de lumière pour obtenir un réseau optique est naturellement une source cohérente, par exemple une source laser, si l'on procède par enregistrement direct. Selon une autre variante, qui sera décrite ultérieurement, on peut cependant utiliser une source incohérente.

L'énergie reçue par le semiconducteur doit être suffisante pour obtenir la création des paires électron-trou mais inférieure à une énergie qui entraînerait un échauffement trop important du matériau et une dégradation de ses qualités cristallines.

De façon plus précise, selon une première variante du procédé, pour obtenir un réseau, il est nécessaire de faire interférer deux ondes. Pour ce faire, on divise le faisceau émis par le laser en deux faisceaux. La surface d'un substrat semiconducteur plongée dans la solution oxydante reçoit directement d'une part, un des faisceaux divisés et, d'autre part, par exemple après réflexion, le deuxième faisceau. Ces deux faisceaux sont agencés de telle manière qu'ils interfèrent dans une région superficielle du substrat semiconducteur.

Le procédé de réalisation d'une structure diffractante selon une première variante de l'invention comprend donc les étapes suivantes qui se chevauchent au moins partiellement ;

-étape 1 : immersion dans une solution oxydante comprenant des éléments d'élimination des oxydes qui se forment ;

-étape 2 : exposition à une irradiation photonique génératrice de paires électron-trou ;

-étape 3 : contrôle du relief obtenu ;

-étape 4 : arrêt du processus lorsque le profil désiré de gravure est obtenu.

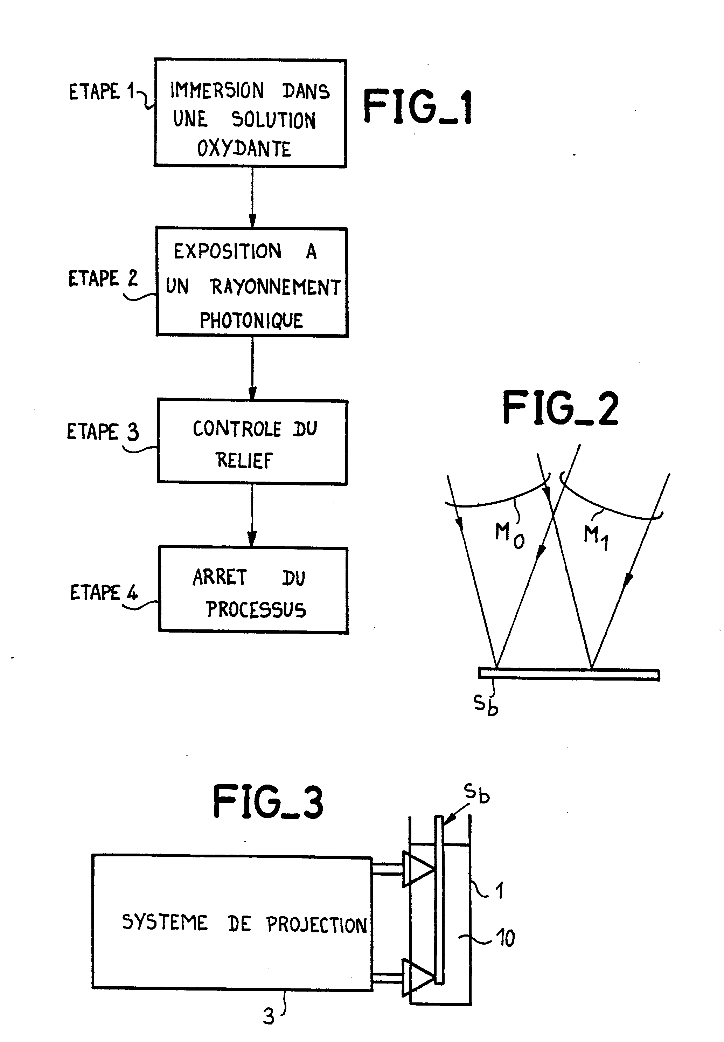

La figure 1 illustre ces étapes, qui vont maintenant être détaillées.

Pour obtenir une gravure sélective avec l'illumination, les réactions chimiques intéressantes sont celles qui font intervenir les porteurs de charges photogénérés : ce sont donc essentiellement des réactions d'oxydoréduction. C'est l'apport de trous en surface $p$ + qui va conditionner la dissolution de mùatériau semiconducteur : S.C.la réaction suit le schéma relationnel suivant :

$$S.C. + p \overset{+}{\underset{BV}{}} \quad S.C.^+$$

relation dans laquelle :

-S.C.est le matériau semiconducteur ;

-S.C.$^+$ est le matériau semiconducteur chargé positivement par l'apport de trous ;

-BV est la bande de valence.

Ensuite on procède :

a)à la solvatation de SC$^+$ qui passe en solution aqueuse :

(SC$^+$)aq

b)et à l'attaque de (SC$^+$)aq par l'agent oxydant de la solution chimique.

La vitesse de gravure dépend du nombre de trous libres dans la bande de valence au voisinage de l'interface matériau-solution.

La vitesse de gravure dépend en premier lieu de la puissance optique du faisceau d'illumination : typiquement, pour une puissance optique de l'énergie lumineuse incidente de 500 mW/cm², la vitesse de gravure est de l'ordre du micromètre par mn.

De façon pratique, le substrat est disposé dans un récipient contenant une solution oxydante qui en outre contient également des éléments nécessaires à la dissolution des oxydes qui vont se former.

Un exemple d'une telle solution est de l'eau oxygénée et de l'acide sulfurique dilué dans de l'eau. La solution est du type $H_2O_2$ : $H_2SO_4$ : $H_2O$.

La solution de ce type offrant les meilleures performances obéit aux proportions suivantes :

$H_2O_2$ : $H_2SO_4$ : $H_2O$ = 1 : 1 : 100.

D'autres solutions peuvent être utilisées, telles que KOH : $H_2O$ dans des proportions relatives 1 : 100 à 1 : 500. On peut encore utiliser une solution d'acide chlorydrique dans de l'eau H Cl : $H_2O$ dans des gammes de proportions analogues ou encore tout autre mélange d'acide dilué ou de base diluée.

Le matériau semiconducteur est par exemple de l'arséniure de gallium dopé n.

Seule la longueur de diffusion L des porteurs limite la taille des motifs pouvant être gravés dans le matériau semiconducteur. Aux longueurs d'ondes du domaine visible, utilisées lors de la photogravure, on a :

L < 0,1 micromètre.

Cette résolution est compatible avec l'enregistrement des structures fonctionnant pour une lecture dans le domaine infrarouge $\lambda_1$ qui correspond à des pas de réseaux élémentaires tels que :

$$\Lambda > \frac{\lambda_1}{2} \approx 5 \text{ micromètres.}$$

Pour réaliser une structure diffractante, il est nécessaire que la gravure ne soit pas uniforme. Au contraire, l'attaque chimique du substrat doit avoir lieu de manière préférentielle dans les zones illuminées et doit révéler un profil de relief contrôlé par la répartition de l'éclairement incident.

Le choix de la source d'illumination revêt une grande importance.

Les longueurs d'ondes utilisées doivent être fortement absorbées par le substrat afin d'augmenter le nombre de photoporteurs en surface et par conséquent la vitesse V de gravure, qui dépend donc de cette longueur d'onde.

L'ordre de grandeur est le suivant;

v = 0,5 µm/s pour $\lambda$ = 514 nm

v = 3µm/s pour $\lambda$ = 257 nm

Le domaine de sensibilité optimale est donc le proche ultraviolet et le visible.

Pour inscrire un motif déterminé, comme illustré par la figure 2, on fait donc interférer deux faisceaux parallèle d'énergie cohérente : $M_0$ et $M_1$. En réalité, ces deux faisceaux peuvent être obtenus par séparation d'un faisceau unique. Ces faisceaux $M_0$ et $M_1$ interfère en surface d'un substrat $S_b$ en matériau semiconducteur.

La figure d'interférence obtenue dépend d'un certain nombre de paramètres parmi lesquels la longueur d'onde, comme il a été rappelé, et l'angle d'incidence. En outre, l'exposition de la surface du substrat peut être sélective. Par ce biais, un motif d'une configuration particulière peut être obtenue.

La figure 3 résume les opérations d'exposition et de photogravure, qui comme il a été rappelé se chevauchent.

Le substrat $S_b$ est plongé dans un bain 10 de la solution oxydante contenu dans un récipient 1 dont les parois sont transparentes aux rayonnements générés par un système de projection 3.

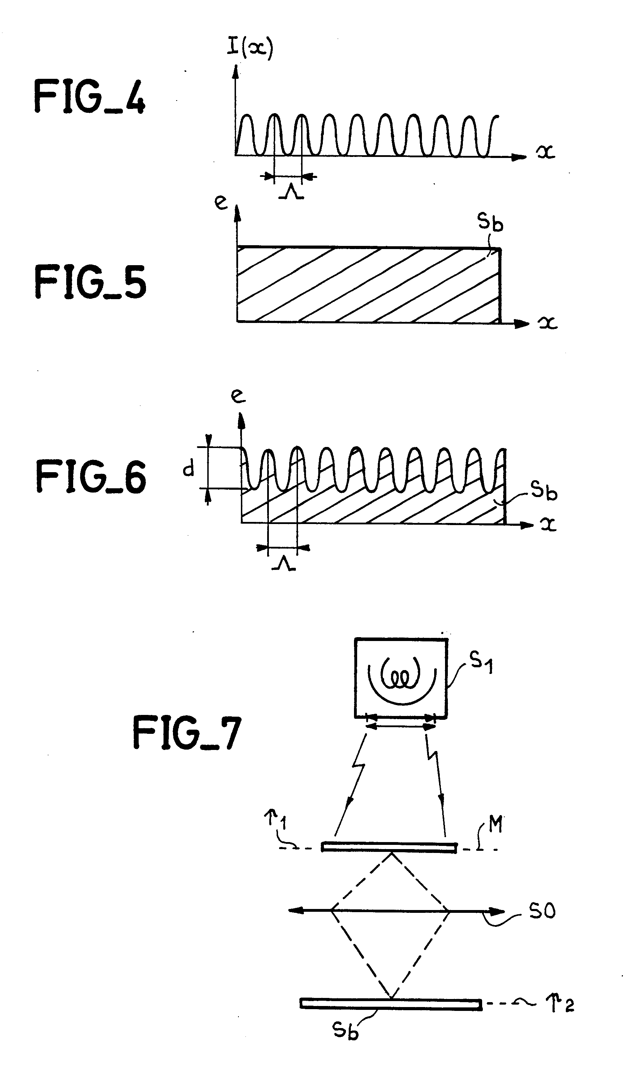

La figure 4 est un diagramme illustrant - schématiquement un exemple particulier de figures d'interférence. L'axe vertical représente les intensités optiques en unités arbitraires et l'axe horizontal, un axe parallèle au plan de la surface. Le pas de la figure d'interférence est .

La figure 5 représente le substrat $S_b$ avant traitement et la figure 6 représente ce même substrat après traitement. L'axe vertical e est perpendiculaire à la surface du substrat plan, l'axe horizontal x étant parallèle à cette surface.

Sur la figure 6, le pas et la profondeur du relief d ont été indiqués. Pour obtenir un réseau profond, il faut donc le rapport (d/ )soit plus grand que l'unité.

Le procédé comprend donc, comme il a été indiqué, des étapes ultérieures de mesure de la profondeur de gravure d par tous moyens appropriés, et d'arrêt du processus lorsque la valeur désirée est atteinte. Le terme "mesure" doit être compris dans son acceptation la plus large. Il englobe une détermination "a priori" par le calcul. De façon préférentielle, on a recours à une mesure "in situ" à l'aide de moyens optiques conventionnels.

Le procédé de l'invention, selon sa première variante qui vient d'être décrite présente l'avantage de pouvoir réaliser sans masque des structures classiques quelconques du type réseau, lentilles, etc..., par interférence de deux fronts d'onde.

Par contre, tout phénomène d'interférence parasite contribue également à la gravure. Ce mode d'inscription nécessite une bonne stabilité du montage au cours des enregistrements.

Aussi, dans une deuxième variante du procédé, on utilise un masque intermédiaire, ce qui permet d'utiliser une source non cohérente.

On procède à une étape supplémentaire de réalisation d'un masque portant un motif à transférer.

Cette variante permet permet d'obtenir é volonté des structures complexes calculées par projection d'un masque sur le substrat. Ce masque est par exemple le résultat d'un hologramme calculé, mais tout autre procédé peut être mis en oeuvre.

L'utilisation d'une source non cohérente permet de s'affranchir des problèmes de stabilité et de réseaux parasites.

La figure 7 illustre schématiquement un appareillage pour la mise en oeuvre de la deuxième variante du procédé de l'invention. Le déroulement des opérations reste cependant conforme au - schéma présenté par la figure 1.

Une source $S_1$ illumine un masque M portant le motif à transférer. Un système optique classique SO conjugue les plans $p_1$ et $p_2$ comprenant respectivement le masque M et la surface du substrat $S_b$ à graver. Ce processus de projection est classique en microlithographie.

La source $S_l$ peut comprendre par exemple une lampe ultaviolette du type quartz ou Xenon.

Comme il a été décrit en relation avec la figure 3, le substrat est plongé dans une solution oxydante.

L'attaque dans le noir est inexistante dans les solutions chimiques basiques mais pour celles-ci les vitesses de gravure restent faibles.

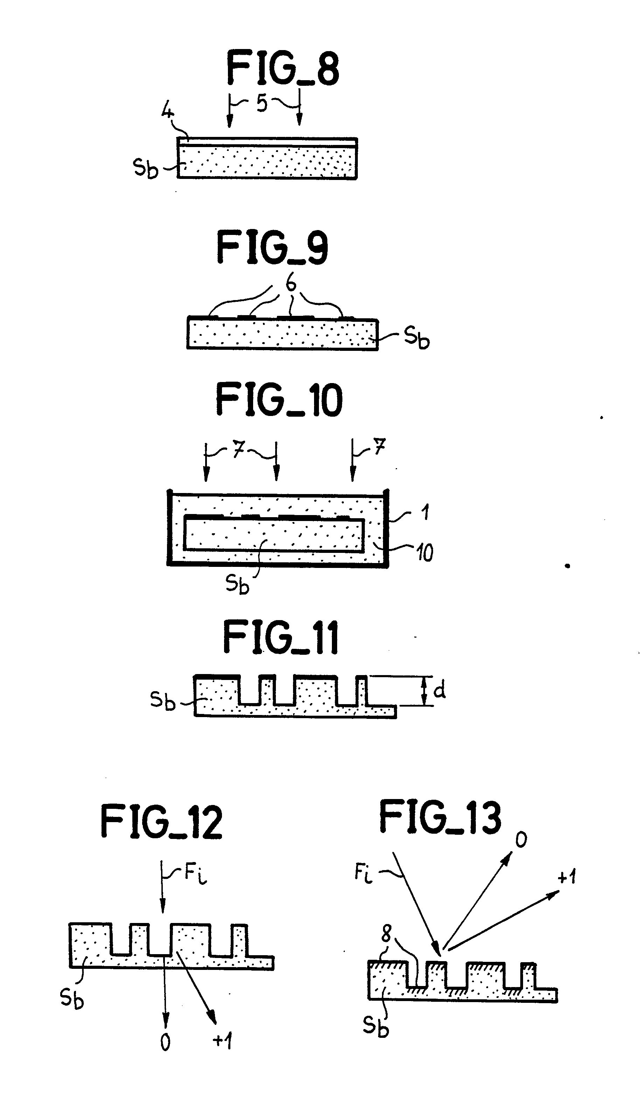

Pour s'affranchir de ce problème lors de l'utilisation de solutions chimiques acides, on procède selon une troisième variante de l'invention qui va maintenant être explicitée en relation avec les figures 8 à 11.

Le substrat $S_b$ est préparé, lors d'une étape préliminaire, en déposant à sa surface une couche de photoresist 4 d'épaisseur de l'ordre de grandeur du micromètre, comme illustré par la figure 8.

Dans une première étape, le motif est enregistré sur le photoresist, à l'aide d'un rayonnement non uniforme 5, qui après développement revélera un profil de relief 6 de faible amplitude comme illustré par la figure 9.

La deuxième étape consiste, comme illustré par la figure 10, à transférer ce relief 6 sur le matériau semiconducteur c'est-à-dire le substrat $S_b$ par gravure photochimique comme il a été décrit antérieurement. Ce transfert est réalisé par simple éclairage uni forme 7 du substrat $S_b$ : la gravure s'effectue uniquement dans les zones non protégées par la résine photoresist et son amplitude est uniquement contrôlée par le temps d'exposition et l'intensité incidente, selon la caractéristique principale de l'invention. Le substrat $S_b$ comme précédemment, est plongé dans une solution acide 10 contenu dans un récipient 1.

Des expériences menées en laboratoire ont montré que l'attaque du photoresist développé est quasiment nulle après avoir séjourné 1/2 H dans des solutions acides de gravure.

Après gravure, comme illustré par la figure 11, le photoresist est dissout. Le substrat $S_b$ présente en surface un réseau dont la profondeur d des reliefs a été déterminé par le temps d'immersion et d'exposition au rayonnement compte tenu de la composition et de la concentration de la solution et de l'énergie optique incidente.

Les composants enregistrés dans le visible par les techniques de gravure photochimique peuvent être restitués dans l'infrarouge dans les deux configurations suivantes:

-en transmission pour les substrats transparents aux longueurs d'onde infrarouges et plus particulièrement à la longueur d'onde $\lambda = 10,6\mu m$;

-ou en réflexion après métallisation du profil en relief par évaporation d'une couche de métal réfléchissante à la longueur d'onde de lecture.

Dans ce dernier cas, l'or est un métal qui convient particulièrement bien à cette application, mais on peut également utiliser l'argent ou l'aluminium, sans que cette liste soit limitative.

La figure 12 illustre le premier mode de lecture.

Le substrat $S_b$ est en matériau transparent à la longueur d'onde $£'$ d'un faisceau incident $F_i$. Ce faisceau interfère avec la structure diffractante gravée et ressort par la face opposée à celle recevant le faisceau incident en produisant des ordres de diffraction dont deux, l'ordre zéro et l'ordre 1, one été représentés.

La figure 13 illustre le second mode le lecture. En général le matériau utilisé est transparent, aussi la surface du substrat $S_b$ a été recouverte d'une mince pellicule de métal 8. Un faisceau incident $F_i$ produit, par réflexion des ordres de diffraction, dont deux, l'ordre zéro et l'ordre un, ont été représentés.

Le procédé de l'invention permet donc d'obtenir des réseaux lisibles dans l'infrarouge, et plus particulièrement à 10,6 micromètres dont le relief présente une profondeur d importante devant le pas des strates .

Les propriétés intéressantes concernant les rendements de diffraction des réseaux de relief peuvent donc être exploitées pour réaliser des composants holographiques efficaces, dans le domaine infrarouge, pour lequel les profondeurs d requises sont importantes : supérieures à 10 micromètres.

Pour fixer les idées, dans le cas d'un profil de type crénelé, de pas $\Lambda$ et de profondeur d, les rendements de diffraction suivants peuvent être atteints dans une configuration en transmission:

-pour $d/\Lambda = 1 : \eta = 75\%$

-pour $d/\Lambda = 2 : \eta = 88,5\%$ ;

et dans une configuration en réflexion :

-pour $d/\Lambda = 0,4 : \eta = 80\%$.

**Revendications**

1. Procédé de réalisation d'une structure diffractante dans le domaine des longueurs d'ondes infrarouges sur un substrat ($S_b$) en matériau semiconducteur, caractérisé en ce qu'il comprend des étapes d'immersion dudit substrat dans une solution oxydante et d'exposition sélective d'une zone superficielle de ce substrat à un rayonnement photonique générateur de paires de porteurs électron-trou de manière à opérer une gravure photoélectrochimique de ladite zone superficielle et en ce que le temps d'exposition est sélectionné pour que la gravure présente des microreliefs de hauteur supérieure ou égale à la distance moyenne séparant deux micro-reliefs contigüs.

2. Procédé selon la revendication 1, caractérisé en ce que l'exposition du rayonnement photonique est produite pas l'interférence de deux faisceaux - ($M_0$, $M_1$) de lumière cohérente de longueur d'onde comprise dans les domaines du visible ou de l'ultraviolet.

Procédé selon la revendication 1, caractérisé en ce qu'il comprend en outre une étape préliminaire de création d'un masque (M) comportant des zones opaques et des zones transparentes selon une configuration déterminée dans le domaine des longueurs d'onde du visible ou de l'ultraviolet et en ce que ladite exposition au rayonnement photonique consiste en l'illumination du substrat ($S_b$) au travers du masque (M) à l'aide d'une source d'énergie lumineuse non cohérente, de longueur d'onde comprise dans ledit domaine de manière à transférer le motif sur ladite zone superficielle.

4. Procédé selon la revendication 1, caractérisé en ce qu'il comprend en outre une étape préliminaire consistant à déposer une couche de matériau photosensible (4) sur ladite zone superficielle du substrat ($S_b$), à illuminer sélectivement cette couche de matériau photosensible (4) à l'aide d'une rayonnement non uniforme (5) d'énergie lumineuse de longueurs d'onde comprise dans le domaine du visible ou de l'ultraviolet, à enlever les zones de ladite couche (4) non illuminées de manière à créer un masque superficiel de configuration prédéterminée (6) et en ce que ladite exposition au rayonnement photonique est réalisée au travers de ce masque superficiel.

5. Procédé selon l'une quelconque des revendications 1 à 4, caractérisé en ce que ledit matériau semiconducteur est à base de silicium, de germanium, d'arséniure de gallium ou du phosphure d'indium.

6. Procédé selon l'une quelconque des revendications 1 à 5, caractérisé en ce que ladite solution oxydante est une solution d'eau oxygénée et d'acide sulfurique diluée dans de l'eau.

7. Procédé selon l'une quelconque des revendications 1 à 5, caractérisé en ce que ladite solution oxydante est une solution d'acide chlorydrique dans de l'eau.

8. Procédé selon l'une quelconque des revendications 1 à 7, caractérisé en ce que ladite structure est diffractante pour une longueur d'onde de 10,6 micromètres.

9. Structure diffractante dans le domaine des longueurs d'onde infrarouges, caractérisée en ce qu'elle comprend un substrat en matériau semiconducteur comportant une gravure superficielle réalisée selon l'une quelconque des revendications 1 à 8.

10. Structure diffractante selon la revendication 9, caractérisée en ce que ladite gravure est un hologramme lisible à une longueur d'onde de 10,6 micromètres.

0 211 715

ETAPE 1 — IMMERSION DANS UNE SOLUTION OXYDANTE

FIG_1

ETAPE 2 — EXPOSITION A UN RAYONNEMENT PHOTONIQUE

ETAPE 3 — CONTROLE DU RELIEF

ETAPE 4 — ARRET DU PROCESSUS

FIG_2

$M_0$  $M_1$

$S_b$

FIG_3

$S_b$

SYSTEME DE PROJECTION

1

10

3

FIG_4

FIG_5

FIG_6

FIG_7

# FIG_8

# FIG_9

# FIG_10

# FIG_11

# FIG_12

# FIG_13

## DOCUMENTS CONSIDERES COMME PERTINENTS

| Catégorie | Citation du document avec indication. en cas de besoin. des parties pertinentes | Revendication concernée | CLASSEMENT DE LA DEMANDE (Int Cl.4) |
|---|---|---|---|
| Y | APPLIED OPTICS, vol. 22, no. 20, octobre 1983, pages 3220-3228, New York, US; R.C. ENGER et al.: "Optical elements with ultrahigh spatial-frequency surface corrugations" * Page 3220, colonne 1, lignes 1-4; colonne 2, lignes 17-22; page 3221, colonne 1, lignes 13-15; figures 5,6 * | 1-8 | G 02 B 5/18 G 02 B 27/44 G 02 B 5/32 G 03 F 7/10 |
| A | IDEM | 9,10 | |
| | --- | | |
| Y | APPLIED PHYSICS LETTERS, vol. 40, no. 5, mars 1982, pages 391-393, American Institute of Physics, New York, US; R.M. OSGOOD et al.: "Localized laser etching of compound semiconductors in aqueous solution" * Page 391, colonne 1, lignes 1-3,21-26; colonne 2, lignes 16,17 * | 1-8 | |
| A | IDEM | 9,10 | |
| | --- -/- | | |

DOMAINES TECHNIQUES RECHERCHES (Int. Cl.4)

G 02 B 5/18
G 02 B 27/44
G 02 B 5/32
G 03 F 7/10

Le present rapport de recherche a été établi pour toutes les revendications

| Lieu de la recherche | Date d achèvement de la recherche | Examinateur |
|---|---|---|
| LA HAYE | 10-10-1986 | WESBY P.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEBForm 1503 03 82

| DOCUMENTS CONSIDERES COMME PERTINENTS | | | Page 2 |
|---|---|---|---|
| Catégorie | Citation du document avec indication, en cas de besoin, des parties pertinentes | Revendication concernée | CLASSEMENT DE LA DEMANDE (Int Cl 4) |
| A | PROCEEDINGS OF THE SOCIETY OF PHOTO-OPTICAL INSTRUMENTATION ENGINEERS, San Diego, California, US, 29 juillet-1 août 1980, vol. 240, pages 243-247, Periodic Structures, Gratings, Moiré Patterns and Diffraction Phenomena, Washington, US; G.J. DUNNING et al.: "Scattering from high efficiency diffraction gratings" * Page 243, lignes 3-5,17,18,26,33-36; page 244; figure 1 * | 1-10 | |
| | --- | | |
| A | APPLIED PHYSICS LETTERS, vol. 43, no. 12, décembre 1983, pages 1083-1085, American Institute of Physics, New York, US; D.V. PODLESNIK et al.: "Maskless, chemical etching of submicrometer gratings in single-crystalline GaAs" * Page 1083, colonne 1, lignes 4-8,28,29,33-37; colonne 2, lignes 18-28; page 1084, colonne 2, lignes 11,12; page 1085, colonne 2, lignes 13-16; figure 3 * | 1-10 | DOMAINES TECHNIQUES RECHERCHES (Int. Cl 4) |
| | ---          -/- | | |
| Le present rapport de recherche a été établi pour toutes les revendications | | | |

| Lieu de la recherche | Date d'achèvement de la recherche | Examinateur |
|---|---|---|
| LA HAYE | 10-10-1986 | WESBY P.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

OEB Form 1503 03 82

## DOCUMENTS CONSIDERES COMME PERTINENTS

Page  3

| Catégorie | Citation du document avec indication, en cas de besoin, des parties pertinentes | Revendication concernee | CLASSEMENT DE LA DEMANDE (Int Cl 4) |
|---|---|---|---|
| A | OPTICS LETTERS, vol. 4, no. 3, mars 1979, pages 96-98, Optical Society of America, New York, US; M. KAZEM SHAMS et al.: "Preferential chemical etching of blazed gratings in (110)-oriented GaAs" * Page 96, colonne 1, lignes 6-8,27-31; colonne 2, lignes 1-14 * | 1-10 | |
| | --- | | |
| A | JOURNAL OF APPLIED PHYSICS, vol. 50, no. 6, juin 1979, pages 3841-3847, American Institute of Physics, New York, US; K. KNOP et al.: "Microfabrication and evaluation of diffractive optical filters prepared by reactive sputter-etching" * En entier * | 1-10 | |
| | ----- | | |

DOMAINES TECHNIQUES
RECHERCHES (Int Cl.4)

Le present rapport de recherche a été établi pour toutes les revendications

| Lieu de la recherche | Date d achèvement de la recherche | Examinateur |
|---|---|---|
| LA HAYE | 10-10-1986 | WESBY P.B. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82